# FASCICULE DE BREVET EUROPEEN

(11) **EP 0 354 080 B1**
(45) Date de publication et mention de la délivrance du brevet: **09.06.1993**
(21) Numéro de dépôt: 89401942.1
(22) Date de dépôt: 06.07.1989
(51) Int. Cl.: G01R 1/073, G01R 31/28

(54) **Adaptateur de brochage pour le test de circuits imprimés de haute densité**
Adapterrahmen zum Prüfen von gedruckten Schaltungen hoher Dichte
Adapter frame for testing printed circuits of high density

(30) Priorité: 08.07.1988 FR 8809306
(43) Date de publication de la demande: 07.02.1990
(73) Titulaire: THOMSON-CSF, 75008 Paris (FR)
(72) Inventeur: Dagnac, Pierre, F-92045 Paris la Défense Cédex 67 (FR); Mourareau, Denis, F-92045 Paris la Défense Cédex 67 (FR)
(74) Mandataire: Benoit, Monique

(56) Documents cités:
- WO-A-86/00173
- FR-A- 2 498 335
- US-A- 3 866 119
- PUBLICATION DE "FEINMETALL GMBH", novembre 1987, Herrnberg, D.: "Prüfkopfe für den IC-Test"
- PATENT ABSTRACTS OF JAPAN, Vol. 6, no. 66 (P-112)(944), 27 avril 1 982; & JP-A-57 008461

## Description

L'invention concerne un adaptateur de brochage pour circuits imprimés nus. Cet adaptateur est notamment utilisé pour réaliser une liaison électrique entre les pastilles conductrices d'un circuit imprimé à tester et les entrées et sorties de moyens de mesure destinées à tester l'isolement et la continuité électrique des pastilles et des pistes conductrices du circuit imprimé.

Un adaptateur de pas classique à aiguilles pour le test de circuits imprimés comporte, pour chaque face des circuits à tester, une matrice d'aiguilles de contact portées par un support isolant et reliées électriquement aux moyens de mesure. Des moyens, en forme de mâchoires par exemple, permettent de presser chaque matrice contre une face du circuit imprimé à tester. Ces aiguilles de contact sont constituées classiquement par des pointes à ressort rigides guidées dans une pièce isolante percée spécialement pour chaque type de circuits imprimés à tester, en fonction de la position des pastilles de ce circuit. Le pas de la base de la matrice d'aiguilles est égal, en général, à 2,54 mm, le pas des circuits imprimés étant de 1,27 mm, ou un sous-multiple de 2,54 mm, il faut donc effectuer un rattrapage de pas de ± 1,27 mm.

Dans les solutions, jusqu'alors proposées, des adaptateurs de pas spécifiques, munis de pointes à ressort, de plaques de guidage et de maintien et d'un circuit d'interconnexion, sont utilisés mais ils coûtent fort cher et ne peuvent être réalisés que pour des circuits en très grande série. D'autres solutions, par exemple, des adaptateurs avec des aiguilles spécifiques très fines, posent le problème de la structure et de la taille des aiguilles de test mais également les problèmes de montage, de positionnement et de distribution, dans le cas de grande densité, de ces aiguilles qui, la plupart du temps, sont montées manuellement. Enfin, des solutions avec des tests sur testeurs capacitifs et des tests associant un test électrique à un contrôle optique ont été aussi élaborées ; la première solution est efficace mais elle est peu utilisée pour des raisons de vitesse de test, on obtient par exemple, des vitesses de tests au plus égales à 150 points minute alors que les tests doivent être faits généralement à une vitesse de 1000 à 2000 points seconde ; la deuxième solution est peu avantageuse pour des raisons de durée et de complexité des tests.

Le but de l'invention est de proposer un adaptateur de brochage permettant de tester des circuits imprimés dont les surfaces de contacts ont un pas inférieur ou égal à celui de l'appareil de test utilisé. Cet adaptateur permet d'employer directement, soit des aiguilles à ressort de l'appareil de test montées sur un substrat isolant que l'on appellera testeur à palpeur, soit des adaptateurs à aiguilles classiques.

L'objet de l'invention est un adaptateur de brochage comportant un substrat sur lequel sont définies, sur une même face, des pastilles conductrices, à un premier pas dû à un système de test, en liaison, par l'intermédiaire de pistes conductrices, avec des contacts disposés à la périphérie des pastilles et situés à un deuxième pas identique à celui des surfaces de contact d'un élément spécifique de circuit imprimé à tester, adaptateur caractérisé en ce que la périphérie du substrat supportant les contacts est repliée et en ce que la partie repliée supportant les contacts est fixée sur le substrat de manière à obtenir deux faces différentes dont l'une supportant les contacts permet le contact avec l'élément de circuit imprimé à tester et l'autre supportant les pastilles conductrices permet d'appliquer le système de test.

Des caractéristiques et avantages de la présente invention apparaîtront à la lecture de la description suivante d'un exemple particulier de réalisation, la description étant faite en relation avec les dessins qui représentent :
- Figure 1 : des adaptateurs de brochage, selon l'invention, positionnés sur un adaptateur classique à aiguilles ;
- Figure 2 : Un substrat permettant de réaliser un adaptateur de brochage selon l'invention ;
- Figure 3 : Une cale, selon l'invention, pour donner une rigidité à l'adaptateur de brochage ;
- Figure 4 : Un schéma de pliage et collage de la cale sur le substrat ;
- Figure 5 : Un schéma de la face supérieure de l'adaptateur de brochage venant au contact des surfaces de contacts du circuit imprimé à tester ;
- Figure 6 : Une coupe latérale d'une vue à plat de l'adaptateur de brochage muni de la cale.

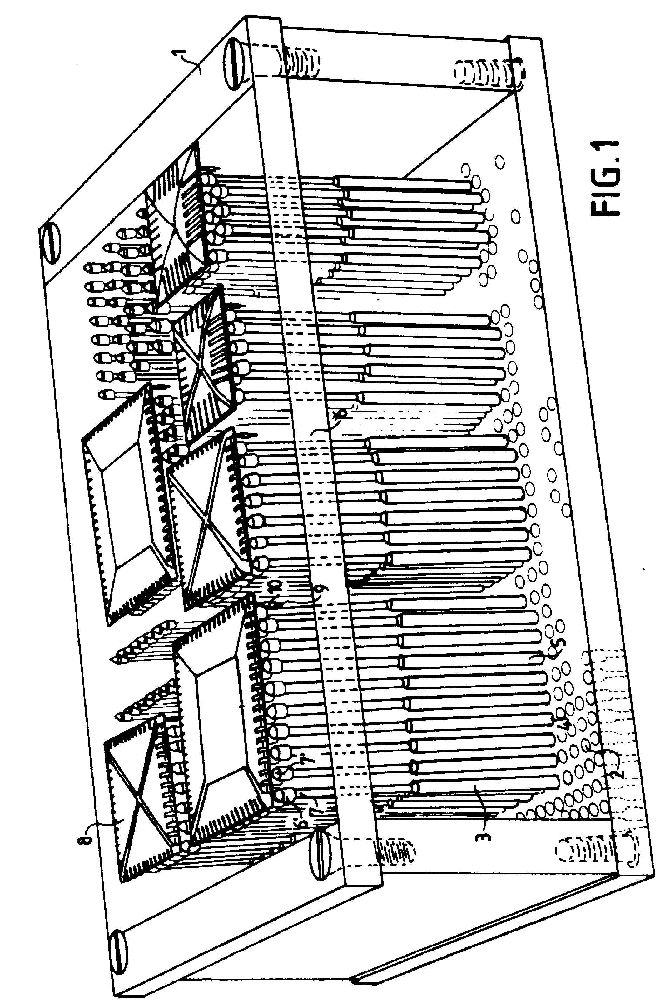

La figure 1 représente des adaptateurs de brochage, selon l'invention, positionnés sur un adaptateur à aiguilles. Il est possible de tester des éléments soit en direct sur des aiguilles, soit par intermédiaire d'un adaptateur de brochage convenable, dès que la densité de points est trop importante par rapport au nombre d'aiguilles disponibles dans la surface considérée.

A chaque emplacement de ces points 2, des aiguilles 3 ont été insérées, par exemple, dans une gorge plastifiée 4 permettant de maintenir l'aiguille dans une position déterminée. L'extrémité supérieure 7 des aiguilles 3 se positionne dans un élément 6 où des trous, munis de gaines plastifiées 6', laissent dépasser la tête 7' de ces aiguilles 3 permettant ainsi une liaison avec un élément. La distance entre chaque tête 7' de ces aiguilles 3 est, par exemple, supérieure ou égale à 1,8 mm ce qui permet un premier rattrapage de pas.

La réalisation d'un tel ensemble est effectuée automatiquement grâce notamment à des données de perçage du circuit à tester et des données des adaptateurs de brochage à utiliser . En effet, grâce à la connaissance des dimensions des composants à tester ainsi qu'à la disposition et l'assemblage des composants sur la carte à tester, on définit la position des différents éléments composant l'adaptateur à aiguilles 1. Sur cet adaptateur à aiguilles 1, des adaptateurs de brochage 8, selon l'invention, sont positionnés sur des aiguilles 3 ; leur positionnement est facilité par deux broches 9, dont l'une n'est pas visible sur le dessin, car elle est située en diagonale de l'autre, venant coulisser, par exemple, dans un cylindre 10, réalisé dans l'élément 6 permettant le guidage et le maintien de l'adaptateur de brochage sur l'adaptateur à aiguilles.

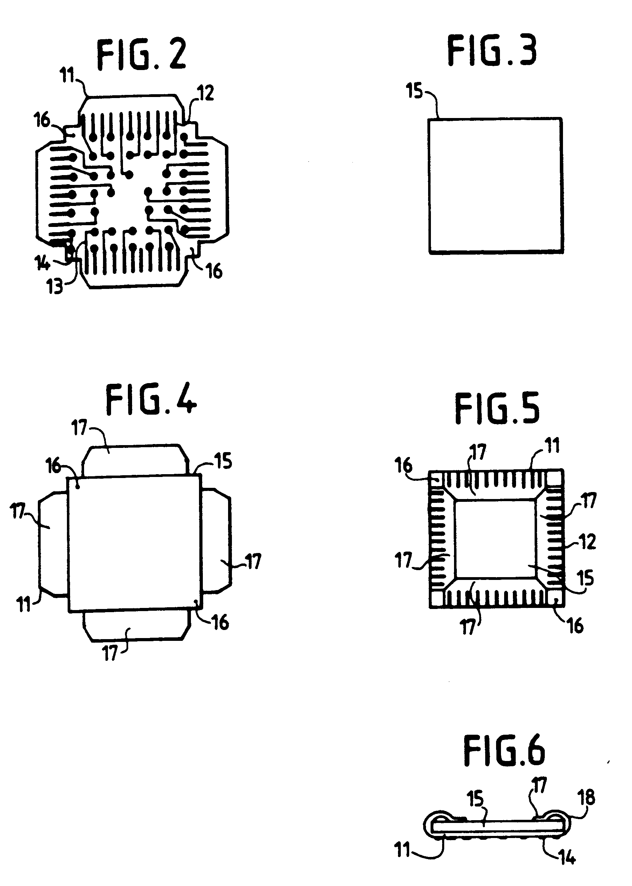

La figure 2 représente un substrat permettant de réaliser l'adaptateur de brochage selon l'invention. Le substrat 11 possède, par exemple, 44 contacts situés, par exemple, à un pas de 1,27 mm. Le matériau isolant utilisé, pour réaliser ce substrat 11, a été choisi de manière à répondre à des caractéristiques de souplesse et d'élasticité ; on emploie, par exemple, le kapton. Ce support souple ou substrat 11 comporte des conducteurs 13, dans notre cas, simple face, mais il est envisageable d'utiliser du double face pour des supports avec un nombre de broches beaucoup plus important, reliant les contacts 12 à des pastilles 14. Le pas entre chacune des pastilles 14 est choisi afin que chaque pastille 14 de l'adaptateur de brochage vienne au contact, par exemple, d'une tête d'aiguille de l'adaptateur à aiguilles. La forme et la taille de ce support ont été déterminées de manière à ce que, après les différentes phases de collage et de pliage du support sur une cale 15 représentée à la figure 3, on obtienne la forme et la taille du composant à tester. Dans le cas d'un substrat simple face, l'utilisation, par exemple, d'un matériau suffisamment rigide et, souple aux extrémités de pliage peut être envisagé ; la réalisation d'un tel adaptateur de brochage est la même que celle décrite, la seule différence résidant en l'absence de la cale 15 qui, d'une part, assure une rigidité de l'adaptateur de brochage lorsque l'on utilise, par exemple, un substrat (11) souple et élastique et, d'autre part, établit une neutralité électrique entre les deux faces réalisées du substrat lorsque l'on emploie, par exemple, un substrat (11) double face. Les pastilles 16 sur le schéma de la figure 2 représentent l'emplacement des broches de guidage et de maintien sur l'adaptateur à aiguilles ; ces dernières sont généralement placées dans la dernière phase de fabrication et de montage de l'adaptateur de brochage.

La figure 4 représente un schéma de pliage et de collage de la cale sur le substrat. La cale 15, constituée, par exemple, d'un élément rigide isolant, se fixe, par exemple, par collage, sur la face du substrat 11 ne comportant pas les pastilles 14. Les éléments 12, 13, 14 représentés sur la figure 2 se trouvent sur la face arrière de la figure 4. La cale 15, dont les dimensions sont calculées par rapport à celles du substrat 11, se superpose au substrat 11 et ne laisse entrevoir que les extrémités 17 du substrat 11 comportant les contacts 12 non représentés mais fixés sur la face arrière. La forme des extrémités 17 a été réalisée de façon à ce que, lors du pliage de ses quatre extrémités, il n'y ait pas de recouvrements entre les extrémités 17.

La figure 5 représente la face supérieure de l'adaptateur venant au contact des surfaces de contact du composant à tester après le collage et le pliage des différents éléments. Les extrémités 17 du substrat 11 ont été pliées de manière à ce que les contacts 12, en liaison avec les pastilles 14 non représentées sur la figure, soient situées en regard des pastilles 14, c'est-à-dire que les pastilles 14 sont sur une face et les contacts 12 sur l'autre. Après avoir effectué ce pliage, les extrémités 17 sont rabattues sur la cale 15 et elles sont maintenues, par exemple, par collage, de façon à obtenir une partie bombée dûe au rayon de courbure ; ce rayon de courbure est déterminée, d'une part, par rapport au positionnement des broches 12 du substrat 11 qui doit être au droit des surfaces de contacts des composants à tester et, d'autre part, de manière à ce que des ruptures de liaisons ne se produisent pas lorsque les mesures sont en cours.

La figure 6 représente une coupe latérale d'une vue à plat de l'adaptateur de pas selon l'invention. La cale 15 est fixée, par exemple, par collage, sur une face du substrat 11 ne supportant pas les pastilles 14. Les extrémités 17 du substrat 11 viennent se rabattre sur l'autre face de la cale 15, par exemple, au moyen d'un outil pneumatique, qui permet de réaliser les opérations de courbage et de collage par pression. Cette figure montre une partie bombée 18, supportant les contacts 12 représentés sur la figure 6, assurant les liaisons électriques . Cette partie bombée 18 est obtenue grâce à un rayon de courbure fixé à partir de la force de pression appliquée sur le circuit imprimé à tester pour établir la liaison électrique entre ce circuit imprimé et l'appareil de test par l'intermédiaire de l'adaptateur de brochage.

Pour utiliser l'adaptateur de brochage ainsi réalisé, il suffit d'insérer deux broches dans les emplacements 16 prévus à cet effet et situés par exemple en diagonale. L'adaptateur de brochage peut être amené sur le testeur à aiguilles où des emplacements permettent l'insertion de ces broches qui, d'une part, positionnent l'adaptateur sur le testeur et le maintiennent et, d'autre part, guident l'adaptateur pendant le mouvement vertical des aiguilles lors de la mise en contact. En effet, pour effectuer les tests de mesure des différents motifs à tester, il suffit de placer sur l'adaptateur à aiguilles équipé des adaptateurs de brochage appropriés, le composant ou circuit imprimé à tester, le testeur à aiguilles étant relié d'une part à un système de mesure approprié et d'autre part à l'adaptateur à aiguilles. Une force de pression est alors exercée sur le circuit imprimé ; cette force établit, d'une part, les contacts électriques nécessaires pour pouvoir réaliser les différentes mesures souhaitées et, d'autre part, elle provoque l'écrasement des aiguilles du testeur à aiguilles qui, grâce à ce mouvement, viennent au contact des pastilles de l'adaptateur de brochage.

L'emploi d'un adaptateur à aiguilles est très généralisé car les positions des surfaces de contact sur les circuits à tester sont souvent à des pas correspondant à des sous-multiples de 2,54 mm. Dans le cas où les surfaces de contact sont distantes d'un pas de 2,54 mm, l'adaptateur à aiguilles n'est plus nécessaire.

La présente invention s'applique à tous les circuits imprimés au pas de 1,27 mm mais on peut envisager d'étudier un adaptateur de brochage de même type pour des circuits imprimés de pas différents. On peut également utiliser cet adaptateur de brochage pour des composants que l'on voudrait tester. La taille de ces adaptateurs de brochage peut également être différente de celle qui est préalablement décrite, en effet, la dimension de l'adaptateur est déterminée par le nombre de surfaces de contacts de l'élément à tester. De nombreuses opérations, en ce qui concerne la réalisation de l'adaptateur de brochage, peuvent être effectuées sur machine automatique permettant ainsi une réalisation rapide, une bonne fiabilité et un coût minimum.

## Revendications

1. Adaptateur de brochage comportant un substrat (11) sur lequel sont définies, sur une même face, des pastilles conductrices (14), à un premier pas dû à un système de test, en liaison, par l'intermédiaire de pistes conductrices (13), avec des contacts (12) disposés à la périphérie des pastilles (14) et situés à un deuxième pas identique à celui des surfaces de contact d'un élément spécifique de circuit imprimé à tester, adaptateur caractérisé en ce que la périphérie du substrat (11) supportant les contacts (12) est repliée et en ce que la partie repliée supportant les contacts (12) est fixée sur le substrat (11) de manière à obtenir deux faces différentes dont l'une supportant les contacts (12) permet le contact avec l'élément de circuit imprimé à tester et l'autre supportant les pastilles conductrices (14) permet d'appliquer le système de test.

2. Adaptateur de brochage selon la revendication 1, caractérisé en ce que la face supportant les contacts (12) et permettant de recevoir le circuit imprimé à tester est formée d'une partie bombée (18) obtenue grâce à un rayon de courbure pour permettre d'établir une liaison électrique assurant les mesures de tests entre des éléments ayant des points de contacts à des pas différents.

3. Adaptateur de brochage selon l'une des revendications précédentes, caractérisé en ce que la partie bombée (18) est réalisée par un outil pneumatique permettant le cambrage et le collage par pression des extrémités (17) du substrat (11).

4. Adaptateur de brochage selon l'une des revendications précédentes, caractérisé en ce qu'il comporte une cale (15).

5. Adaptateur de brochage selon l'une des revendications précédentes, caractérisé en ce que la cale (15) est positionnée, entre les deux faces réalisées sur le substrat (11) par pliage et collage, pour permettre d'obtenir d'une part, une rigidité de l'adaptateur de brochage et d'autre part, une neutralité électrique entre les deux faces réalisées.

6. Adaptateur de brochage selon l'une des revendications précédentes, caractérisé en ce que le nombre de contacts de l'adaptateur de brochage est déterminé par le nombre de surfaces de contact du circuit imprimé à tester correspondant au brochage d'un composant fixé sur le circuit imprimé.

7. Adaptateur de brochage selon l'une des revendications précédentes, caractérisé en ce qu'il comporte des broches (9) permettant l'insertion sur un adaptateur à aiguilles.

8. Adaptateur de brochage selon l'une des revendications précédentes, caractérisé en ce que les broches (9) sont insérées en force, dans le substrat par une machine outil permettant également le pressage.

9. Adaptateur de brochage selon l'une des revendications précédentes, caractérisé en ce que le pas entre les contacts (12) est fixé en fonction du pas entre les surfaces de contacts du circuit imprimé ou du composant.

10. Adaptateur de brochage selon l'une des revendications précédentes, caractérisé en ce que le substrat (11) est souple et élastique.

11. Adaptateur de brochage selon l'une des revendications précédentes, caractérisé en ce que le substrat (11) est un substrat simple face.

## Patentansprüche

1. Anschlußadapter mit einem Substrat (11), auf dem auf der gleichen Seite Leiteranschlußflächen (14) entsprechend einer sich aus einem Testsystem ergebenden ersten Teilung festgelegt sind, die über Leiterbahnen (13) mit Kontakten (12) verbunden sind, die an der Peripherie der Anschlußflächen (14) vorgesehen und entsprechend einer zweiten Teilung angeordnet sind, die mit der der Kontaktoberflächen eines speziellen, zu testenden gedruckten Schaltungselements identisch ist, dadurch gekennzeichnet, daß der die Kontakte (12) tragende Rand des Substrats (11) umgeschlagen ist und daß der die Kontakte (12) tragende umgeschlagene Teil an dem Substrat (11) so festgelegt ist, daß zwei unterschiedliche Seiten erhalten werden, von denen die eine Seite, die die Kontakte (12) trägt, den Kontakt mit dem zu testenden gedruckten Schaltungselement gestattet und die andere Seite, die die Leiteranschlußflächen (14) trägt, die Verwendung des Testsystems ermöglicht.

2. Anschlußadapter nach Anspruch 1, dadurch gekennzeichnet, daß die Seite, die die Kontakte (12) trägt und die Annahme der zu testenden gedruckten Schaltung gestattet, durch einen gewölbten Teil (18) gebildet ist, der aufgrund eines Krümmungsradius erhalten wird, um die Herstellung einer elektrischen Verbindung zu ermöglichen, die die Testmessungen zwischen den Elementen sicherstellt, die Kontaktstellen bei unterschiedlichen Teilungen aufweisen.

3. Anschlußadapter nach einem der vorhergehenden Ansprüche, dadurch gekennzeichnet, daß der gewölbte Teil (18) durch ein Pneumatikwerkzeug hergestellt ist, das das Biegen und das Kleben der Enden (17) des Substrats (11) durch Druck gestattet.

4. Anschlußadapter nach einem der vorhergehenden Ansprüche, dadurch gekennzeichnet, daß er eine Einlage (15) enthält.

5. Anschlußadapter nach einem der vorhergehenden Ansprüche, dadurch gekennzeichnet, daß die Einlage (15) zwischen den beiden Seiten angeordnet ist, die an dem Substrat (11) durch Umschlagen und Kleben verwirklicht sind, um einerseits eine Steifheit des Anschlußadapters zu erzielen und andererseits eine elektrische Neutralität zwischen den beiden hergestellten Seiten zu erhalten.

6. Anschlußadapter nach einem der vorhergehenden Ansprüche, dadurch gekennzeichnet, daß die Anzahl von Kontakten des Anschlußadapters durch die Anzahl von Kontaktflächen der zu testenden gedruckten Schaltung entsprechend dem Anschluß eines auf der gedruckten Schaltung befestigten Bauelements festgelegt ist.

7. Anschlußadapter nach einem der vorhergehenden Ansprüche, dadurch gekennzeichnet, daß er Stifte (9) aufweist, die das Aufsetzen auf einen Nadeladapter gestatten.

8. Anschlußadapter nach einem der vorhergehenden Ansprüche, dadurch gekennzeichnet, daß die Stifte (9) unter Einwirkung einer Kraft durch eine Werkzeugmaschine in das Substrat eingebracht sind, die auch das Pressen gestattet.

9. Anschlußadapter nach einem der vorhergehenden Ansprüche, dadurch gekennzeichnet, daß die zwischen den Kontakten (12) vorgesehene Teilung in Abhängigkeit von der zwischen den Kontaktflächen der gedruckten Schaltung oder des Bauelements vorgesehenen Teilung festgelegt ist.

10. Anschlußadapter nach einem der vorhergehenden Ansprüche, dadurch gekennzeichnet, daß das Substrat (11) biegsam und elastisch ist.

11. Anschlußadapter nach einem der vorhergehenden Ansprüche, dadurch gekennzeichnet, daß das Substrat (11) ein einseitiges Substrat ist.

## Claims

1. A connection adapter comprising a substrate (1) on which there are defined, on one single surface thereof, conducting areas (14) with a first pitch corresponding to a test apparatus and connected by the intermediary of conducting tracks (13), with contacts (12) arranged on the periphery of the conducting areas (14) and positioned with a second pitch identical with that of contact surfaces of a specific printed circuit element to be tested, said adapter being characterized in that the periphery of the substrate (11) bearing the contacts (12) is folded back and in that the folded part is secured on the substrate (11) in such a manner as to present two different surfaces of which one bearing the contacts (12) renders possible contact with the printed circuit element to be tested and the other bearing the conducting areas (14) renders possible the application of the test apparatus.

2. The connection adapter as claimed in claim 1, characterized in that the surface bearing the contacts (12) and making it possible to engage the printed circuit to be tested is formed by an outwardly curved part (18) obtained by having a radius of curvature in order to permit the establishment of an electrical connection ensuring the performance of testing measures between the elements having contact points with different pitches.

3. The connection adapter as claimed in any one of the preceding claims, characterized in that the outwardly curved part (18) is produced by pneumatic means rendering possible the curving and welding by pressure of the ends (17) of the substrate (11).

4. The connection adapter as claimed in any one of the preceding claims, characterized in that it comprises a shim (15).

5. The connection adapter as claimed in any one of the preceding claims, characterized in that the shim (15) is positioned, between the two surfaces produced on the substrate (11) by bending and welding, in order to permit ensuring on the one hand rigidity of the connection adapter and on the other hand an electrical neutrality between the two surfaces produced.

6. The connection adapter as claimed in any one of the preceding claims, characterized in that the number of contacts of the adapter is determined by the number of contact surfaces of the printed circuit to be tested corresponding to the test connection of a component secured on the printed circuit.

7. The connection adapter as claimed in any one of the preceding claims, characterized in that it comprises pins (9) rendering possible insertion on a needle adapter.

8. The connection adapter as claimed in any one of the preceding claims, characterized in that the pins (9) are inserted with a force fit into the substrate by a machine tool also permitting pressing.

9. The connection adapter as claimed in any one of the preceding claims, characterized in that the pitch of the contacts (12) is set as a function of the pitch between the surfaces with contacts of the printed circuit or of the component.

10. The connection adapter as claimed in any one of the preceding claims, characterized in that the substrate (11) is flexible and elastic.

11. The connection adapter as claimed in any one of the preceding claims, characterized in that the substrate (11) is a single surface substrate.
